# EUROPÄISCHE PATENTSCHRIFT

(11) **EP 2 553 477 B1**
(45) Veröffentlichungstag und Bekanntmachung des Hinweises auf die Patenterteilung: **08.04.2020**
(21) Anmeldenummer: 11714220.8
(22) Anmeldetag: 28.03.2011
(51) Int. Cl.: G01R 31/02, G01R 31/14, G01R 27/26

(54) **VORRICHTUNG UND VERFAHREN ZUR DIAGNOSE VON MESSOBJEKTEN UNTER VERWENDUNG EINER MESSSPANNUNG**
DEVICE AND METHOD FOR DIAGNOSING TEST OBJECTS USING A MEASURING VOLTAGE
DISPOSITIF ET PROCÉDÉ DE DIAGNOSTIC D'OBJETS DE MESURE EN UTILISANT UNE TENSION DE MESURE

(30) Priorität: 29.03.2010 DE 102010013103
(43) Veröffentlichungstag der Anmeldung: 06.02.2013
(73) Patentinhaber: b2 electronics GmbH, 6833 Klaus (AT)
(72) Erfinder: BLANK, Rudolf, A-6832 Sulz (AT); BALDAUF, Stefan, A-6830 Rankweil (AT)
(74) Vertreter: Grättinger Möhring von Poschinger Patentanwälte Partnerschaft mbB
(86) Internationale Anmeldenummer: PCT/EP2011/001541
(87) Internationale Veröffentlichungsnummer: WO 2011/124338

(56) Entgegenhaltungen:
- US-A- 4 112 354
- US-A- 5 329 064
- US-A1- 2004 227 520
- US-A1- 2008 099 227

## Beschreibung

Die vorliegende Erfindung betrifft eine Vorrichtung zur Diagnose von Messobjekten unter Verwendung einer auf das jeweilige Messobjekt einwirkenden Messspannung, umfassend einen Hochspannungsgenerator zur Erzeugung der Messspannung und eine elektrische Messschaltung zur Durchführung der Diagnose sowie die Verwendung einer solchen Vorrichtung. Ferner betrifft die Erfindung auch ein Verfahren zur Durchführung einer Diagnose unter Verwendung einer solchen Vorrichtung.

Eine Vorrichtung der eingangs genannten Art ist beispielsweise aus der WO 2007/045004 A1 bekannt. Bei den mit einer solchen Vorrichtung zu prüfenden Messobjekten handelt es sich insbesondere um (Hochspannungs-)Kabel oder sonstige elektrische oder elektronische Bauteile, wie z.B. Kondensatoren, Spulen, etc., die durch Anlegen einer Messspannung und Auswertung bzw. Messung des hierbei im Messobjekt erzeugten Stromflusses einer technischen Diagnose unterzogen werden können.

Im Rahmen der Diagnose (z.B. eines Kabels) ist im Stand der Technik sowie im Rahmen der vorliegenden Erfindung insbesondere an die (zerstörungsfreie) Bestimmung des sog. Verlustfaktors zu denken, der eine Aussage zur Güte bzw. der noch zu erwartenden Lebensdauer des betreffenden Messobjekts (z.B. eines Hochspannungskabels) erlaubt. Diagnose im Sinne der vorliegenden Erfindung kann die Messung und der Vergleich des Phasenwinkels der Messspannung und des hierdurch im Messobjekt erzeugten Stroms und/oder die Aufzeichnung eines Ausschwingvorgangs der Spannung und/oder des hierdurch in dem Messobjekt erzeugten Stroms und/oder die Aufzeichnung von Teilentladungsvorgängen in Messobjekten und/oder die Laufzeitmessung an zu prüfenden Messobjekten sein.

Zu insoweit üblichen Diagnosezwecken kann z.B. eine sinusförmige Wechselspannung dienen, wobei dann unter Auswertung des hierdurch im Kabel erzeugten Stroms, d.h. unter Auswertung von dessen Amplitude und/oder dessen Phase in Relation zur Amplitude und/oder Phase der Messspannung auf eine bestimmte Charakteristik des jeweiligen Messobjekts (z.B. dessen Verlustfaktor) geschlossen werden kann. Auch die Verwendung einer Gleichspannung oder sonstiger Spannungsimpulse mit einem vorab definierten Verlauf der Spannungsamplitude kommt als geeignete Messspannung - unter Auswertung der in einem Stromfluss bestehenden Antwort des Messobjekts - zu üblichen Diagnosezwecken in Betracht.

Der bei einer gattungsgemäßen Vorrichtung vorgesehene Hochspannungsgenerator kann entweder mit der übrigen Vorrichtung in baulicher Einheit (z.B. innerhalb eines gemeinsamen Gehäuses) angeordnet sein oder als separates Bauteil zur Verfügung stehen, das über eine geeignete Schnittstelle, insbesondere über ein in das Gehäuse der übrigen Vorrichtung hineingeführtes Koaxialkabel, mit der elektrischen Messschaltung der Diagnose- bzw. Prüfvorrichtung verbunden ist.

Die in der WO 2007/045004 A1 beschriebene Vorrichtung weist einen mit der Messspannung beaufschlagten Anschlussadapter auf, an welchem das zu prüfende Messobjekt direkt anzuschließen ist. Ferner umfasst die Messschaltung der Vorrichtung eine mit dem Anschlussadapter verbundene Stromerfassungseinrichtung sowie eine Spannungserfassungseinrichtung, deren Ausgangssignale an eine Auswerteeinheit weitergeleitet werden. Die Auswerteeinheit dient dabei der - vorzugsweise digitalen - Auswertung, Speicherung und/oder Aufbereitung der gewonnenen Messwerte, um diese mittels einer Datenübertragungseinrichtung an eine externe Datenverarbeitungseinheit weiterzugeben und/oder zur unmittelbaren Auswertung der eingehenden Signale, z.B. im Sinne einer Bestimmung des Verlustfaktors eines als Messobjekt dienenden Kabels. Das Ergebnis dieser Messung bzw. Diagnose kann dann gegebenenfalls über eine geeignete Messwert- bzw. Daten-Anzeigeeinrichtung der Vorrichtung angezeigt werden.

Nachteilig an dem vorgenannten Stand der Technik ist jedoch, dass hiermit jeweils nur ein Messobjekt gleichzeitig geprüft werden kann. Ferner muss diese Vorrichtung wegen des geforderten direkten Anschlusses des jeweiligen Messobjekts an den Anschlussadapter der Vorrichtung sehr nahe an das zu prüfende Messobjekt herangebracht werden, was in Anbetracht des üblichen Gewichts gattungsgemäßer Vorrichtungen und der teilweise auch schweren Erreichbarkeit/Zugänglichkeit von häufig fest verbauten Messobjekten (wie z.B. Hochspannungskabeln) ebenfalls nachteilig ist.

Weiterhin sind Diagnosevorrichtungen der eingangs genannten Art bekannt, bei welchen die Messschaltung zur Durchführung der Diagnose (insbesondere die hierbei zum Einsatz kommende Stromerfassungseinrichtung) niederspannungsseitig angeordnet ist, wobei der durch die Messspannung induzierte Stromfluss im Messobjekt gegen Erdpotential gemessen wird. In diesem Zusammenhang ist auch die Verwendung eines Verbindungskabels zwischen der eigentlichen Messvorrichtung und dem Messobjekt bekannt. Insbesondere im Rahmen der Vermessung einer Mehrzahl an Messobjekten, z.B. allen drei Adern eines drei-phasigen Hochspannungskabels, ergibt sich jedoch auch hier der Nachteil, dass mit besagter Vorrichtung in einem Messvorgang immer nur ein einziges Messobjekt (z.B. eine einzelne Ader des betreffenden Hochspannungskabels) geprüft werden kann, was insbesondere bei entfernt von den Messobjekten erfolgender Aufstellung der Vorrichtung zeitintensiv ist. Aufgrund der niederspannungsseitigen Anordnung der Messschaltung ist es dabei sogar schaltungstechnisch unmöglich mehrere Messobjekte, z.B. alle drei Adern eines drei-phasigen Hochspannungskabels, gleichzeitig zu vermessen, jedenfalls wenn nicht entweder die Schutzerdeanschlüsse aller Adern des betreffenden Kabels zum Zwecke der Stromerfassung (unter Zwischenschaltung einer Stromerfassungseinrichtung) geöffnet werden sollen oder wenn nicht eine Mehrzahl an Hochspannungsgeneratoren zum Einsatz kommen soll. Die Öffnung des Schutzerdeanschlusses eines verlegten Hochspannungskabels wird jedoch in der Regel nicht gewünscht bzw. ist sehr aufwändig, so dass bei niederspannungsseitiger Anordnung der Messschaltung stets eine nacheinander erfolgende Diagnose der einzelnen Adern des zu prüfenden Hochspannungskabels erfolgen muss.

Aus der US 2004/227520 A1 ist ferner eine Vorrichtung zur Diagnose von Messobjekten unter Verwendung einer auf das jeweilige Messobjekt einwirkenden Messspannung bekannt, welche einen Hochspannungsgenerator zur Erzeugung der Messspannung und eine elektrische Messschaltung zur Durchführung der Diagnose umfasst. Diese Vorrichtung ist zur gleichzeitigen Diagnose von wenigstens zwei Messobjekten eingerichtet und weist hierzu eine Mehrzahl an messspannungsseitig liegenden, separaten Anschlusselementen auf, wobei jedem Messobjekt eines der Anschlusselemente zugeordnet ist. Dabei weist die Messschaltung eine Mehrzahl an messspannungsseitig liegen liegenden Stromerfassungseinrichtungen auf,
die zur gleichzeitigen Messung des jedem Messobjekt zuordenbaren Stromes mit je einem Anschlusselement in Kontakt stehen. Besondere Maßnahmen, wie ein Verbindungskabel zur Verbindung der verschiedenen Anschlusselemente mit den Messobjekten ausgestaltet sein könnte und/oder verbessert werden könnte, sind darin nicht offenbart.

Aus der US 4,112,354 A ist zudem eine fest in einem Fahrzeug installierbare Vorrichtung zur Durchführung von Teilentladungsmessungen an Hochspannungskabeln bekannt, wobei auch dort keine speziellen Maßnahmen beschrieben sind, mit denen unter Verwendung spezieller Verbindungskabel zuverlässige und gleichzeitige Messung mehrerer Messobjekte erzielbar ist.

Weiterhin zeigen schließlich die US 5, 329, 064 A und die US 2008/0099227 A1 verschiedene Kabelgestaltungen, bei denen jedoch kein näherer Bezug zu den vorliegenden in Rede stehenden Mess- bzw. Diagnosevorrichtungen erkennbar ist.

Vor diesem Hintergrund ist die Aufgabe der vorliegenden Erfindung, eine möglichst einfach aufgebaute und im Hinblick auf seinen Aufstellort flexible Mess- bzw. Diagnosevorrichtung der eingangs genannten Art bereitzustellen, mit welcher einerseits eine möglichst zeitsparende Diagnose einer Mehrzahl an Messobjekten ermöglicht ist und andererseits der hiermit in Zusammenhang stehende Aufwand verringert wird.

Diese Aufgabe wird mit einer Vorrichtung gemäß Anspruch 1, einer Verwendung der Vorrichtung gemäß Anspruch 8 sowie dem Verfahren gemäß Anspruch 9 gelöst.

Die erfindungsgemäße Vorrichtung zeichnet sich neben den bereits eingangs genannten Merkmalen dadurch aus, dass sie zur gleichzeitigen Diagnose von wenigstens zwei Messobjekten eingerichtet ist und hierzu eine Mehrzahl an auf Messspannungspotential liegenden, separaten Anschlusselementen aufweist, wobei jedem Messobjekt eines der Anschlusselemente zugeordnet ist. Erfindungsgemäß ist ferner vorgesehen, dass die Messschaltung eine Spannungserfassungseinrichtung zur Messung der an allen Anschlusselementen gleichermaßen anliegenden Messspannung sowie eine Mehrzahl an Stromerfassungseinrichtungen aufweist, wobei die Stromerfassungseinrichtungen auf Messspannungspotential (d.h. hochspannungsseitig) liegen und zur gleichzeitigen Messung des jedem Messobjekt zuordenbaren Stromes mit je einem Anschlusselement in Kontakt stehen. Außerdem ist im Rahmen der Erfindung vorgesehen, dass die Vorrichtung wenigstens ein mindestens 10 Meter langes Verbindungskabel zur Verbindung der Messobjekte mit den ihnen jeweils zugeordneten Anschlusselementen aufweist, wobei das wenigstens eine Verbindungskabel neben einer bzw. mehreren den jeweiligen Messobjekten zugeordneten Ader(n) eine weitere, nicht zur Kontaktierung eines Messobjekts dienende Ader umfasst, welcher ebenfalls ein (separates) auf Messspannungspotential liegendes Anschlusselement an der Vorrichtung zugeordnet ist und mit welcher bei Verbindung der Ader mit dem ihr zugeordneten Anschlusselement ein im Verbindungskabel entstehender Leckstrom einer messschaltungsseitig angeordneten Leckstromableitung der Vorrichtung zuführbar ist. Schließlich ist noch vorgesehen, dass alle Adern des Verbindungskabels von einer halbleitenden oder leitenden Schicht umhüllt sind, welche mit der der Leckstromableitung dienenden Ader des Verbindungskabels in elektrischem Kontakt steht und welche von einer Hauptisolation des Verbindungskabels umgeben ist. Die vorliegende Erfindung erzielt gegenüber dem vorbekannten Stand der Technik eine Mehrzahl an Vorteilen. Zum einen können verschiedene Messobjekte, die zu Prüf-bzw. Diagnosezwecken einer gleichen Mess- bzw. Prüfspannung ausgesetzt werden sollen, mit der erfindungsgemäßen Vorrichtung gleichzeitig vermessen werden und müssen nicht mehr nacheinander an eine geeignete Messvorrichtung angeschlossen und einer jeweils separaten Diagnose unterzogen werden, was eine deutliche Zeitersparung mit sich bringt. Ferner ergibt sich in Anbetracht des Umstands, dass alle im erfindungsgemäßen Sinne simultan geprüften Messobjekte der gleichen Messspannung ausgesetzt werden, der weitere Vorteil, dass die dabei erzielten Mess- bzw. Diagnoseergebnisse besser vergleichbar sind, da alle Messobjekte im Rahmen eines Messvorgangs mit identischer Messspannung beaufschlagt wurden. Bei separaten und nacheinander erfolgenden Messungen bzw. Diagnosen einzelner Messobjekte, wie dies im Stand der Technik erfolgt, ist eine solch zuverlässige Vergleichbarkeit der gewonnenen Daten nicht gegeben. Ferner bedarf es im Rahmen der vorliegenden Erfindung nur einer Hochspannungsquelle für die gleichzeitige Diagnose einer Mehrzahl an (baugleichen oder bauverschiedenen) Messobjekten, wobei im Falle eines separaten Hochspannungsgenerators auch nur eine Zuleitung zu der übrigen Vorrichtung vorgesehen sein muss. Weiterhin wird der mit einem entsprechenden Diagnosevorgang verbundene Aufwand im Rahmen der vorliegenden Erfindung auch dadurch deutlich reduziert, dass die Messobjekte nicht direkt an entsprechenden Anschlusselementen der Vorrichtung, sondern mittels wenigstens eines mindestens 10 Meter langen Verbindungskabels dort angeschlossen werden. Dies gibt ein großes Maß an Flexibilität im Hinblick auf den Aufstellort der erfindungsgemäßen Vorrichtung, welcher entsprechend fern der Messobjekte liegen kann.

Diese Flexibilität wird im Rahmen der vorliegenden Erfindung dadurch gewonnen, dass - bei gleichzeitig hochspannungsseitiger Anordnung der verschiedenen Stromerfassungseinrichtungen, die erst eine gleichzeitige Messung des den verschiedenen Messobjekten zuordenbaren Stroms ermöglicht - das (wenigstens eine) Verbindungskabel eine zusätzliche Ader aufweist, mittels derer der im Verbindungskabel unvermeidlich entstehende Leckstrom einer Leckstromableitung zugeführt wird. Als Leckstromableitung ist dabei eine Verschaltung des der betreffenden Ader zugeordneten Anschlusselements zu verstehen, mit welcher der Leckstrom derart abgeführt wird, dass er nicht durch die den Messobjekten zugeordneten Stromerfassungseinrichtungen hindurchgeleitet wird.

Bei erfindungsgemäßer Verwendung (wenigstens) eines - vorteilhaft flexiblen - Verbindungskabels zur Kontaktierung der zu prüfenden Messobjekte ist nämlich auch der in dem betreffenden Verbindungskabel, abhängig von dessen Güte und Länge, entstehende Leckstrom zu berücksichtigen, der bei nicht vorhandener Leckstromableitung das gewünschte Messergebnis nicht unbeträchtlich verfälschen würde. Insoweit sei angemerkt, dass der Verlustfaktor des Verbindungskabels sogar den Verlustfaktor eines zu prüfenden Hochspannungskabels überschreiten kann, so dass die Ableitung des Leckstroms bzw. dessen Erfassung (z.B. mittels einer Leckstromerfassungseinrichtung) als durchaus wesentlich für die Güte der Diagnose anzusehen ist. Eine rein rechnerische Berücksichtigung des bei bekannter Messspannung zu erwartenden Leckstroms ist nämlich nicht in jedem Fall zielführend, da sich dieser in der Regel nicht linear zur Höhe der angelegten Spannung verhält und somit insbesondere bei komplexen Diagnosevorgängen nicht einfach aus dem erzielten Messergebnis herausrechenbar ist. Zudem ist zu berücksichtigen, dass sich auch die Güte eines geeigneten Verbindungskabels auf längerer Zeitskala verschlechtern kann.

Bei der Spannungserfassungseinrichtung einer erfindungsgemäßen Vorrichtung kann es sich in üblicher Weise um einen Spannungsteiler handeln, mit welchem ein für die Messspannung charakteristisches Spannungssignal z.B. einer Auswerteeinheit der Messschaltung zugeführt werden kann. Die erfindungsgemäß vorgesehenen Stromerfassungseinrichtungen der Messschaltung sind bevorzugt in Art eines Nebenschlusswiderstands (shunt) ausgeführt, bei welchem der an dem (bevorzugt niederohmigen) elektrischen Widerstand erzeugten Spannungsabfall als Messgröße für den Stromfluss dient und z.B. ebenfalls einer Auswerteeinheit der Messschaltung zugeführt wird.

Die bereits genannte Auswerteeinheit ist bevorzugt in die erfindungsgemäße Vorrichtung integriert und dient vorteilhaft zur gleichzeitigen(vorteilhaft digitalen) Auswertung aller die Strom- bzw. und Spannungsmessung für mehrere Messobjekte betreffenden Signale. Dabei ist insbesondere an eine simultane Erfassung und Speicherung der von den Strom- bzw. Spannungserfassungseinrichtungen ausgegebenen Signale zu verstehen. Insbesondere können mittels der Auswerteeinheit jedoch auch bereits weitere Diagnose- bzw. Berechnungsschritte (z.B. die Berechnung des Verlustfaktors aller gleichzeitig geprüfter Messobjekte) erfolgen. Da die Messschaltung der erfindungsgemäßen Vorrichtung bevorzugt inkl. der Auswerteeinheit vollständig hochspannungsseitig (d.h. auf Messspannungspotential) angeordnet ist, ist es ferner vorteilhaft, wenn eine etwaige Datenübertragungseinrichtung der Vorrichtung, die dann vorteilhaft ebenfalls hochspannungsseitig angeordnet sein kann, zur drahtlosen Übertragung der Mess- bzw. Diagnoseergebnisse an eine externe Datenverarbeitungsanlage eingerichtet ist. Insoweit kann auf bekannte Übertragungsstandards, z.B. Bluetooth, WLAN, etc., zurückgegriffen werden. Auch die Verwendung einer Infrarotschnittstelle oder eine optische Datenübertragung können wegen deren Unabhängigkeit von einem elektrischen Spannungspotential vorteilhaft Verwendung finden.

In einer ersten bevorzugten Weiterbildung der vorliegenden Erfindung ist vorgesehen, dass die Vorrichtung insgesamt genau ein mehradriges Verbindungskabel von wenigstens 10 Metern Länge aufweist, wobei jedem Messobjekt eine Ader des Verbindungskabels zugeordnet ist, mit welcher das Messobjekt zum Zwecke der Diagnose mit dem ihm zugeordneten Anschlusselement in leitfähige Verbindung gebracht wird. Die Kontaktierung einer Mehrzahl an Messobjekten, z.B. den drei Adern eines zu prüfenden Hochspannungskabels, mit der ansonsten entfernt aufgestellten Messvorrichtung kann somit mittels eines einzigen Verbindungskabels erfolgen. Eine zusätzliche Ader des Verbindungskabels ist dabei mit einem der Leckstromableitung dienenden Anschlusselement der Vorrichtung verbunden, wobei angemerkt sei, dass unter dem Begriff "Ader" vorliegend jedweder (separate) Leiter eines Verbindungskabels verstanden werden kann.

Eine weitere bevorzugte Ausgestaltung der Erfindung sieht vor, dass die Vorrichtung zur gleichzeitigen Diagnose von insgesamt drei Messobjekten eingerichtet ist und hierzu insgesamt drei auf Messspannungspotential liegende Anschlusselemente und drei mit den jeweiligen Anschlusselementen in Kontakt stehende Stromerfassungseinrichtungen aufweist, wobei es sich bei den Messobjekten um die drei Adern eines drei-phasigen Hochspannungskabels handelt, welche zum Zwecke der Diagnose mit den ihnen zugeordneten Adern des wenigstens eines Verbindungskabels der Vorrichtung in Kontakt gebracht werden. Dies spiegelt das bevorzugte Anwendungsgebiet der vorliegenden Erfindung wider, für welches sich die erfindungsgemäße Vorrichtung in besonders vorteilhafter Weise eignet.

Ferner ist vorteilhaft vorgesehen, dass das wenigstens eine Verbindungskabel eine Länge von ca. 20 bis 200 m, nochmals bevorzugt eine Länge von 50 bis 100 m aufweist. Hierdurch gewinnt man ein außerordentlich großes Maß an Flexibilität im Hinblick auf den Aufstellort der in der Regel zu den Messobjekten zu bringenden Messvorrichtung, während andererseits die Länge des Kabels noch für die gewünschten Prüf- bzw. Diagnosezwecke geeignet ist, insbesondere da bei der erfindungsgemäßen Vorrichtung im vorstehend bereits erläuterten Sinne eine Leckstromableitung realisiert ist.

Für die ein Hauptanwendungsgebiet der vorliegenden Erfindung darstellende Verlustfaktormessung (Tangens-Delta-Messung) an 3-phasigen Hochspannungskabeln ist in besonders bevorzugter Weise vorgesehen, dass der Hochspannungsgenerator zur Erzeugung einer als Messspannung dienenden Wechselspannung (vorteilhaft sinusförmig) mit einem Effektivwert von mehr als 1 kV, bevorzugt mehr als 20 kV oder nochmals bevorzugt mehr als 50 kV eingerichtet ist. Eine typische Frequenz bei solchen Messungen liegt bei ca. 0,1 Hz, wobei der Hochspannungsgenerator einer erfindungsgemäßen Vorrichtung bevorzugt auch ein breites Frequenzspektrum (z.B. von 0,001 Hz bis 1 kHz) abdecken können sollte.

Insbesondere bei der Verwendung eines einzigen, mehradrigen, vorteilhaft flexiblen Verbindungskabels zur Kontaktierung der verschiedenen Messobjekte ist bevorzugt vorgesehen, dass die den einzelnen Messobjekten zugeordneten Adern des Verbindungskabels jeweils mittels einer auf wenigstens 100 V, bevorzugt mehrere 100 V, ausgelegten Isolierung untereinander isoliert sind. Trotz der Verwendung deutlich höherer Messspannungen im kV Bereich kommt es hierbei nicht zu einer nachteiligen Beschädigung des Verbindungskabels, da an allen Adern des Verbindungskabels (inkl. der der Leckstromableitung dienenden Ader) die gleiche Messspannung anliegt, so dass - bei Zugrundelegung optimaler Bedingungen - keine bzw. keine hohen Potentialdifferenzen zwischen den verschiedenen Adern des Verbindungskabels zu erwarten sind. Nichts desto trotz kann im Sinne der Vermeidung einer etwaigen Beschädigung der Messschaltung bevorzugt ein jedem Anschlusselement zugeordneter Überspannungsschutz installiert sein, um bei einem etwaigen Spannungsdurchschlag im Verbindungskabel (z.B. im Falle einer Beschädigung desselben) die Messschaltung und eine gegebenenfalls darin integrierte Auswerteeinheit zu schützen.

Die Adern des Verbindungskabels sind gemäß der Erfindung von einer halbleitenden oder leitenden Schicht umhüllt, welche mit der der Leckstromableitung dienenden Ader des Kabels in elektrischem Kontakt steht, wobei die halbleitende bzw. leitende Schicht von einer Hauptisolation des Kabels umgeben ist. Die der Leckstromableitung dienende Ader des Verbindungskabels benötigt also selbst keine eigene Isolierung. Die Hauptisolation des Verbindungskabels muss dann jedoch geeignet hoch ausgelegt sein und kann hierzu aus einem insoweit üblichen Material bestehen (z.B. XLPE; EPR; etc.). Sie ist in einer nochmals vorteilhaften Weiterbildung dann ihrerseits nochmals von einer weiteren Halbleiterschicht umgeben, der sich ein zu erdendes Schirmgeflecht anschließt, welches wiederum von einer üblichen Außenisolation umgeben ist.

Ein Verbindungskabel der vorgenannten Art, welches vorteilhaft also drei isolierte Adern und eine nicht isolierte Ader aufweist, wird auch bei Kabellängen von bis zu 200 m noch den für die vorstehend genannten Diagnosezwecken bestehenden Anforderungen gerecht.

Eine erfindungsgemäße Vorrichtung der vorstehend erläuterten Art kann vorteilhaft fest in einem Messfahrzeug verbaut sein. Die Kontaktierung der Messobjekte kann dann in besonders einfacher Weise mittels des bis zu etwa 200 m langen Kabels erfolgen, ohne dass die Vorrichtung in unmittelbare Nähe der Messobjekte gebracht werden muss.

Wie bereits weiter oben erwähnt, betrifft die Erfindung auch ein Verfahren zur Durchführung einer gleichzeitigen Diagnose einer Mehrzahl an Messobjekten unter Verwendung einer Vorrichtung der vorstehend erläuterten Art, welches durch die folgenden Schritte gekennzeichnet ist:
A) Herstellen eines leitfähigen Kontakts zwischen den einzelnen Messobjekten und den ihnen zugeordneten Anschlusselementen der Vorrichtung unter Verwendung des wenigstens einen Verbindungskabels der Vorrichtung sowie Anschluss der wenigstens einen der Leckstromableitung dienenden Ader des wenigstens einen Verbindungskabels an ein der Leckstromableitung dienendes Anschlusselement der Vorrichtung
B) Erzeugung einer im Hochspannungsbereich liegenden Messspannung mittels des Hochspannungsgenerators
C) Gleichzeitiges Messen der Messspannung mittels der Spannungserfassungseinrichtung und der den einzelnen Messobjekten zuordenbaren Ströme mittels der wenigstens zwei Stromerfassungseinrichtungen.

Es versteht sich von selbst, dass für das erfindungsgemäße Verfahren die gleichen Aspekte und vorteilhaften Weiterbildungen gelten, wie sie vorstehend für die erfindungsgemäße Vorrichtung bereits erläutert wurden. Insoweit sei also zur Vermeidung von Wiederholungen auf die obigen Ausführungen verwiesen.

Nachfolgend wird ein Ausführungsbeispiel der Erfindung noch anhand der beigefügten Zeichnung erläutert. Dabei zeigt
- Fig. 1: einen schematischen Schaltplan eines Ausführungsbeispiels der vorliegenden Erfindung,
- Fig. 2: eine Darstellung eines in dem erfindungsgemäßen Ausführungsbeispiel vorteilhaft zur Verwendung kommenden Verbindungskabels und
- Fig. 3: ein Flussdiagramm des erfindungsgemäßen Verfahrens.

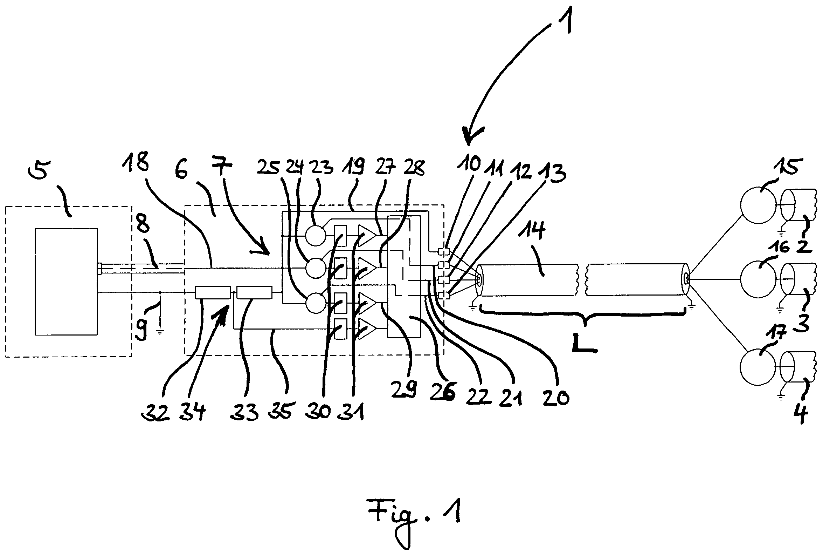

Die in Fig. 1 schematisch gezeigte Vorrichtung 1 dient der gleichzeitigen Diagnose, insbesondere der Bestimmung des so genannten Verlustfaktors, von drei Messobjekten 2, 3, 4, bei welchen es sich vorliegend um die drei Adern eines 3-phasigen Hochspannungskabels handelt.

Hierzu umfasst die Vorrichtung 1 einen programmierbaren Hochspannungsgenerator 5, der vorliegend baulich getrennt von der übrigen Vorrichtung 6, die insbesondere die Messschaltung 7 beinhaltet, ausgeführt ist. Der Hochspannungsgenerator 6 ist mittels eines Koaxialkabels 8 an den die Messschaltung 7 beinhaltenden Teil 6 der Vorrichtung 1 angeschlossen, wobei Hochspannungstransformator 5 und Messschaltung 7 eine gemeinsame Erdung 9 aufweisen.

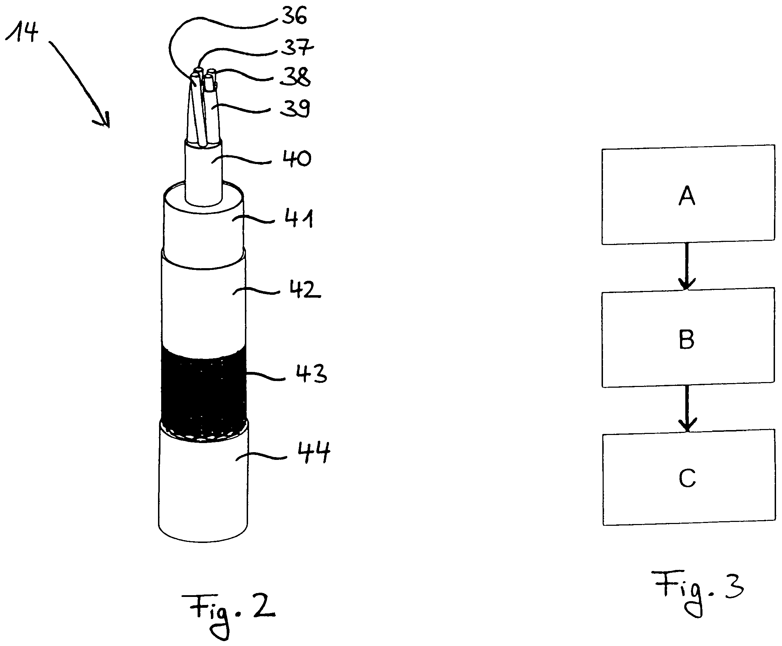

Die Vorrichtung 1 weist insgesamt vier Anschlusselemente 10, 11, 12, 13 auf, an welchen die vorliegend insgesamt vier Adern eines Verbindungskabels 14 mit einer Länge L (von z.B. 100 Metern) angeschlossen sind. Zum Anschluss der Adern des Verbindungskabel 14 an der Messschaltung 7 kann das Verbindungskabel 14 an seinem der Messschaltung 7 zugewandten Ende beispielsweise mit einem geeigneten Stecker ausgestattet sein, der mit einer hierzu korrespondieren Buchse verbindbar ist. Eine bevorzugte Ausführungsart des Verbindungskabels 14 ist nachfolgend anhand der Darstellung in Fig. 2 erläutert.

Drei - an den Anschlusselementen 11, 12, 13 angeschlossene bzw. anzuschließende - Adern des Verbindungskabels 14 dienen der Herstellung eines leitfähigen Kontakts zwischen den Anschlusselementen 11, 12, 13 und den drei zu prüfenden Messobjekten 2, 3, 4, wobei hierzu die Adern am messobjektseitigen Ende des Verbindungskabels 14 - vorliegend über je einen kugelförmigen Hochspannungsadapter 15, 16, 17 - jeweils mit dem der betreffenden Ader zugeordneten Messobjekt 2, 3, 4 verbunden sind bzw. werden. Damit ist jedem Messobjekt 2, 3, 4 genau ein Anschlusselement 11, 12, 13 an der Vorrichtung 1 zugeordnet. Es versteht sich, dass im Rahmen der vorliegenden Erfindung nicht zwingend für alle Messobjekte 2, 3, 4 ein gemeinsames Verbindungskabel Verwendung finden muss, sondern dass stattdessen z.B. für jedes Messobjekt 2, 3, 4 auch ein separates Verbindungskabel Verwendung finden könnte.

Die von dem Hochspannungsgenerator bereit gestellte Messspannung liegt über eine geeignete Leiteranordnung 18, 19, 20, 21, 22 gleichermaßen an allen vier Anschlusselementen 10, 11, 12, 13 der Vorrichtung 1 an.

Im Leitungspfad zwischen Hochspannungsgenerator 5 und den drei den Messobjekten 2, 3, 4 zugeordneten Anschlusselementen 11, 12, 13 ist je eine Stromerfassungseinrichtung 23, 24, 25 angeordnet, mit welcher die über das Verbindungskabel 14 übertragene "Strom-Antwort" der jeweiligen Messobjekte 2, 3, 4 auf die Messspannung erfasst werden kann. Die auf Messspannungspotential liegenden Stromerfassungseinrichtungen 23, 24, 25 sind hierzu über je einen Leiter 20, 21, 22, der in Fig. 1 teilweise hinter der Auswerteeinheit 26 verläuft (was durch gestrichelte Darstellung angedeutet ist) mit den Anschlusselementen 11, 12, 13 verbunden.

Jede Stromerfassungseinrichtung 23, 24, 25 ist außerdem über einen separaten Leitungspfad 27, 28, 29 mit entsprechenden Eingängen einer digitalen Auswerteeinheit 26 verbunden, um ein für den jeweiligen Stromfluss durch die betreffende Stromerfassungseinrichtung 23, 24, 25 charakteristisches Signal an die Auswerteeinheit 26 zu übertragen. In den Leitungspfaden 27, 28, 29 können ggfs., wie dies in Fig. 1 dargestellt ist, jeweils ein Überspannungsschutz 30 und ein Signalfilter bzw. - verstärker 31 angeordnet sein.

Zur Erfassung der gleichermaßen an allen Anschlusselementen 10 - 13 anliegenden - Messspannung umfasst die Messschaltung 7 einen aus zwei geeignet dimensionierten Widerständen 32, 33 bestehenden Spannungsteiler 34, mit welchem über den Leitungspfad 35 ein für die Messspannung charakteristisches Signal der Auswerteeinheit 26 zugeführt werden kann. Der Spannungsteiler 34 ist bevorzugt hochohmig ausgestaltet, d.h. die Summe der beiden Widerstände 32, 33 kann vorteilhaft in einem Bereich größer 100 MΩ (Megaohm) gewählt werden. Demgegenüber weist der Hochspannungsgenerator 5 vorteilhaft einen um mehrere Größenordnungen geringeren Widerstandswert auf, der z.B. im kΩ-Bereich liegen kann. In der Leitung 35 können wiederum ggfs. ein Überspannungsschutz 30 und ein Signalfilter bzw. -verstärker 31 angeordnet sein.

Eine vierte Ader des Verbindungskabel 14 ist innerhalb des Verbindungskabels, bevorzugt über dessen gesamte Länge L, mit einer alle Adern des Verbindungskabels 14 umgebenden leitenden oder halbleitenden Schicht (vgl. Fig. 2) verbunden und an ihrem messschaltungsseitigen Ende an einem ebenfalls auf Messspannungspotential liegenden Anschlusselement 10 angeschlossen.

So kann der gesamte, d.h. der durch alle anderen - den jeweiligen Messobjekten 2, 3, 4 zugeordneten - Adern verursachte Leckstrom der - auf Messspannungspotential liegenden - Leckstromableitung 19 zugeführt werden, wobei die Leckstromableitung 19 infolge ihrer Anordnung dafür Sorge trägt, dass der Leckstrom nicht durch die Stromerfassungseinrichtungen 23, 24, 25 fließt und somit das dortige Messergebnis verfälscht. Der Leckstrom wird vorliegend über die Hochspannungsquelle 5 abgeführt. Ggfs. kann in der Leckstromableitung 19 zur Erfassung bzw. Berücksichtigung des Leckstroms eine mit der Auswerteeinheit 26 zu verbindende Leckstromerfassungseinrichtung (nicht dargestellt) vorgesehen werden.

Die in der Auswerteeinheit 26 zusammengeführten Werte für die Messspannung und die gleichzeitig gemessenen Stromflüsse in allen drei Messobjekten 2, 3, 4 erlauben dann die gewünschte Diagnose der Messobjekte 2, 3, 4, z.B. im Rahmen einer Berechnung des dem jeweiligen Messobjekt 2, 3, 4 zuzuordnenden Verlustfaktors bzw. einer sonstigen Größe.

Die Berechnung und Anzeige des Mess-/Diagnose-Ergebnisses kann - z.B. mittels eines geeigneten Mikroprozessors - direkt in bzw. an der Vorrichtung 1 erfolgen, wozu ggfs. eine geeignete Anzeigevorrichtung an der Vorrichtung 1 vorzusehen ist. Ferner kann vorgesehen sein, dass die gewonnenen Messwerte zur weiteren Bearbeitung / Speicherung an eine externe Datenverarbeitungsanlage übertragen werden.

Fig. 2 zeigt den Aufbau eines im Rahmen der Erfindung verwendbaren Verbindungskabels 14, welches insgesamt vier leitfähige Adern 36, 37, 38, 39 aufweist. Drei der Adern 36, 37, 38 sind individuell isoliert und dienen der Herstellung einer leitfähigen Verbindung zwischen je einem Messobjekt 2, 3, 4 und dem dem jeweiligen Messobjekt 2, 3, 4 zugeordneten Anschlusselement 11, 12, 13 der Vorrichtung 1. Die vierte Ader 39 ist ihrerseits nicht eigenständig isoliert, sondern steht innerhalb des Verbindungskabels 14 vielmehr in leitfähigem Kontakt mit einer - alle Adern 36-39 des Verbindungskabels 14 umhüllenden - Halbleiterschicht 40. Der im Verbindungskabel 14 insgesamt entstehende Leckstrom kann daher über die vierte Ader 39 abgeführt werden, wozu diese an dem mit der Leckstromableitung 19 verbundenen Anschlusselement 10 der Vorrichtung anzuschließen ist.

Auf die Halbleiterschicht 40 (die auch durch eine leitfähige Schicht ersetzt werden könnte) folgt die Hauptisolation 41 des Verbindungskabels 14, der sich nochmals eine Halbleiterschicht 42 anschließt, die ihrerseits von einem Leitergeflecht 43 umgeben ist, bevor die Außenisolation 44 des Verbindungskabels 14 dieses vervollständigt.

Fig. 3 zeigt ein Ablauf- bzw. Flussdiagramm des erfindungsgemäßen Verfahrens, aus welchem sich ergibt, dass sich die Verfahrensschritte A, B, C in der genannten Reihenfolge einander anschließen.

## Patentansprüche

1. Vorrichtung (1) zur Diagnose von Messobjekten (2,3,4) unter Verwendung einer auf das jeweilige Messobjekt (2,3,4) einwirkenden Messspannung, umfassend einen Hochspannungsgenerator (5) zur Erzeugung der Messspannung und eine elektrische Messschaltung (7) zur Durchführung der Diagnose, wobei die Vorrichtung (1) zur gleichzeitigen Diagnose von wenigstens zwei Messobjekten (2,3,4) eingerichtet ist und hierzu eine Mehrzahl an
auf Messspannungspotential liegenden, separaten Anschlusselementen (11,12,13) aufweist, wobei jedem Messobjekt (2,3,4) eines der Anschlusselemente (11,12,13) zugeordnet ist, wobei die Messschaltung (7) eine Spannungserfassungseinrichtung (34) zur Messung der an allen Anschlusselementen (11,12,13) gleichermaßen anliegenden Messspannung sowie eine Mehrzahl an Stromerfassungseinrichtungen (23,24,25) aufweist,
wobei die Stromerfassungseinrichtungen (23,24,25) auf Messspannungspotential liegen und zur gleichzeitigen Messung des jedem Messobjekt (2,3,4) zuordenbaren Stromes mit je einem Anschlusselement (11,12,13) in Kontakt stehen,
wobei die Vorrichtung wenigstens ein mindestens 10 Meter langes Verbindungskabel (14) zur Verbindung der Messobjekte (2,3,4) mit den ihnen jeweils zugeordneten Anschlusselementen (11,12,13) aufweist, wobei das wenigstens eine Verbindungskabel (14) neben einer bzw. mehreren den jeweiligen Messobjekten zugeordneten Ader(n) (37,38,39) eine weitere, nicht zur Kontaktierung eines Messobjekts (2,3,4) dienende Ader (36) umfasst, welcher ebenfalls ein auf Messspannungspotential liegendes Anschlusselement (10) an der Vorrichtung (1) zugeordnet ist und mit welcher bei Verbindung der Ader (36) mit dem ihr zugeordneten Anschlusselement (10) ein im Verbindungskabel (14) entstehender Leckstrom einer messschaltungsseitig angeordneten Leckstromableitung (19) der Vorrichtung (1) zuführbar ist und
wobei alle Adern (36,37,38,39) des Verbindungskabels (14) von einer halbleitenden oder leitenden Schicht (40) umhüllt sind, welche mit der der Leckstromableitung dienenden Ader (36) des Verbindungskabels (14) in elektrischem Kontakt steht und welche von einer Hauptisolation (41) des Verbindungskabels (14) umgeben ist.

2. Vorrichtung nach Anspruch 1,
**dadurch gekennzeichnet,**
**dass** in der Leckstromableitung (19) eine Leckstromerfassungseinrichtung vorgesehen ist.

3. Vorrichtung nach Anspruch 1 oder 2,
**dadurch gekennzeichnet,**
**dass** die Vorrichtung (1) genau ein mehradriges Verbindungskabel (14) von wenigstens 10 Metern Länge aufweist, wobei jedem Messobjekt (2,3,4) eine Ader (37,38,39) des Verbindungskabels (14) zugeordnet ist, mit welcher das jeweilige Messobjekt (2,3,4) zum Zwecke der Diagnose mit dem ihm zugeordneten Anschlusselement (11,12,13) in leitfähige Verbindung gebracht wird.

4. Vorrichtung nach einem der vorangehenden Ansprüche,
**dadurch gekennzeichnet,**
**dass** die Vorrichtung (1) zur gleichzeitigen Diagnose von insgesamt drei Messobjekten (2,3,4) eingerichtet ist und hierzu drei
auf Messspannungspotential liegende Anschlusselemente (11,12,13) zum Anschluss der den drei betreffenden Messobjekten (2,3,4) zuzuordnenden Adern (36,37,38) des wenigstens einen Verbindungskabels (14) und drei mit den jeweiligen Anschlusselementen (11,12,13) in Kontakt stehende Stromerfassungseinrichtungen (23,24,25) aufweist, wobei es sich bei den Messobjekten (2,3,4) um die drei Adern eines 3-phasigen Hochspannungskabels handelt, welche zum Zwecke der Diagnose ihrerseits mit den ihnen zugeordneten Adern (37,38,39) des wenigstens einen Verbindungskabels (14) der Vorrichtung (1) in Kontakt gebracht werden.

5. Vorrichtung nach einem der vorangehenden Ansprüche,
**dadurch gekennzeichnet,**
**dass** das wenigstens eine Verbindungskabel (14) eine Länge (L) von 20 - 200 Metern, besonders bevorzugt von 50 bis 100 Metern, aufweist.

6. Vorrichtung nach einem der vorangehenden Ansprüche,
**dadurch gekennzeichnet,**
**dass** der Hochspannungsgenerator (5) zur Erzeugung einer als Messspannung dienenden Wechselspannung mit einem Effektivwert von mehr als 1 kV, bevorzugt mehr als 20 kV oder nochmals bevorzugt mehr als 50 kV eingerichtet ist.

7. Vorrichtung nach Anspruch 3 und Anspruch 6,
**dadurch gekennzeichnet,**
**dass** die den einzelnen Messobjekten (2,3,4) zugeordneten Adern (37,38,39) des Verbindungskabels (14) mittels einer auf wenigstens 100 V ausgelegten Isolierung untereinander isoliert sind.

8. Verwendung einer Vorrichtung nach einem der vorangehenden Ansprüche,
**dadurch gekennzeichnet,**
**dass** die Vorrichtung (1) fest in einem Messfahrzeug verbaut ist.

9. Verfahren zur Durchführung einer gleichzeitigen Diagnose einer Mehrzahl an Messobjekten (2,3,4) unter Verwendung einer Vorrichtung (1) nach einem der Ansprüche 1 - 7 **gekennzeichnet durch** die folgenden Schritte:
A) Herstellen eines leitfähigen Kontakts zwischen den einzelnen Messobjekten (2,3,4) und den ihnen zugeordneten Anschlusselementen (11,12,13) der Vorrichtung (1) unter Verwendung des wenigstens einen Verbindungskabels (14) der Vorrichtung (1) sowie Anschluss der wenigstens einen der Leckstromableitung dienenden Ader (36) des wenigstens einen Verbindungskabels (14) an ein der Leckstromableitung dienendes Anschlusselement (10) der Vorrichtung (1)
B) Erzeugung einer im Hochspannungsbereich liegenden Messspannung mittels des Hochspannungsgenerators (5)
C) Gleichzeitiges Messen der Messspannung mittels der Spannungserfassungseinrichtung (34) und der den einzelnen Messobjekten (2,3,4) zuordenbaren Ströme mittels der wenigstens zwei Stromerfassungseinrichtungen (23,24,25).

## Claims

1. A device (1) for diagnosing measurement objects (2, 3, 4) through use of a measurement voltage acting upon the respective measurement object (2, 3, 4), said device comprising a high-voltage generator (5) for generating the measurement voltage and an electrical measuring circuit (7) for performing the diagnosis, wherein the device (1) is designed for simultaneously diagnosing at least two measurement objects (2, 3, 4) and for this purpose has a plurality of separate connection elements (11, 12, 13) in contact with the measurement voltage potential, wherein each measurement object (2, 3, 4) is associated with one of the connection elements (11, 12, 13), wherein the measuring circuit (7) has a voltage detection apparatus (34) for measuring the measurement voltage applied equally to all connection elements (11, 12, 13), as well as a plurality of current detection apparatuses (23, 24, 25), wherein the current detection apparatuses (23, 24, 25) are connected to the measurement voltage potential and each is in contact with a respective measurement object (2, 3, 4) for simultaneously measuring the respective current that can be associated with each connection element (11, 12, 13), wherein the device has at least one at least 10 meter long connection cable (14) for connecting the measurement objects (2, 3, 4) with the respective connection elements associated with them (11, 12, 13), wherein the at least one connecting cable (14) comprises, in addition to the one or the plurality of wire(s) (37, 38, 39) associated with the respective measurement objects, another wire (36) which does not serve for contacting a measurement object (2, 3, 4), which wire also is associated with a connection element (10) on measurement voltage potential at the device (1), and which wire (36), when it is connected with the connection element (10) associated with it, can be used to feed a leakage current generated in the connecting cable (14) to a leakage current discharge element (19) of the device (1) arranged on the measuring-circuit side, and wherein all wires (36, 37, 38, 39) of the connection cable (14) are surrounded by a semiconducting or conducting layer (40), which is in electrical contact with the wire (36) of the connection cable (14) serving for discharging the leakage current and which is covered by a main insulation (41) of the connection cable (14).

2. The device according to Claim 1,
**characterized in that**
a leakage current detection apparatus is provided in the leakage current discharge element (19).

3. The device according to Claim 1 or 2,
**characterized in that**
the device (1) has exactly one multi-wire connection cable (14) of at least 10 meters in length, wherein each measurement object (2, 3, 4) is associated with a wire (37, 38, 39) of the connection cable (14), via which the respective measurement object (2, 3, 4) is connected to the connection element (11, 12, 13) associated with it for diagnostic purposes.

4. The device according to any one of the preceding claims,
**characterized in that**
the device (1) is designed for simultaneously diagnosing a total of three measurement objects (2, 3, 4) and for this purpose has three connection elements on the measurement voltage potential (11, 12, 13) for connecting the wires (36, 37, 38) of the at least one connecting cable (14) to be associated with the three respective measurement objects (2, 3, 4), and has three current detection apparatuses (23, 24, 25) which are in contact with the respective connection elements (11, 12, 13), wherein the measurement objects (2, 3, 4) are the three wires of a three-phase high-voltage cable, which in turn are brought into contact with their associated wires (37, 38, 39) of the at least one connection cable (14) of the device (1) for diagnostic purposes.

5. The device according to any one of the preceding claims,
**characterized in that**
the at least one connection cable (14) has a length (L) of 20 - 200 meters, particularly preferably of 50 to 100 meters.

6. The device according to any one of the preceding claims,
**characterized in that**
the high-voltage generator (5) is designed for generating an alternating-current voltage serving as the measurement voltage with an effective value of more than 1 kV, preferably more than 20 kV or further preferably more than 50 kV.

7. The device according to Claim 3 and Claim 6,
**characterized in that**
the wires (37, 38, 39) of the connection cable (14) associated with the individual measurement objects (2, 3, 4) are insulated from each other by means of an insulation designed to withstand at least 100 V.

8. A use of a device according to any one of the preceding claims,
**characterized in that**
the device (1) is firmly installed in a measurement vehicle.

9. A method for performing a simultaneous diagnosis of a plurality of measurement objects (2, 3, 4) using a device (1) according to any one of Claims 1-7, **characterized by** the following steps:
A) establishing a conductive contact between the individual measurement objects (2, 3, 4) and their associated connection elements (11, 12, 13) of the device (1), using the at least one connection cable (14) of the device (1), as well as connecting the at least one wire (36) of the at least one connection cable (14) serving to discharge the leakage current to a connection element (10) of the device (1) serving to discharge the leakage current;
B) generating a measurement voltage in the high-voltage range by means of the high-voltage generator (5);
C) simultaneously measuring the measurement voltage by means of the voltage detection apparatus (34), and measuring the respective currents which can be associated with the individual measurement objects (2, 3, 4) by means of the at least two current detection apparatuses (23, 24, 25).

## Revendications

1. Dispositif (1) destiné à diagnostiquer des objets à mesurer (2, 3, 4) à l'aide d'une tension de mesure agissant sur l'objet à mesurer (2, 3, 4) respectif, comprenant un générateur de haute tension (5) destiné à produire la tension de mesure et un circuit de mesure (7) destiné à exécuter le diagnostic, le dispositif (1) étant conçu pour diagnostiquer simultanément au moins deux objets à mesurer (2, 3, 4) et présentant à cette fin une pluralité d'éléments de raccordement (11, 12, 13) séparés se trouvant à un potentiel de tension de mesure, chaque objet à mesurer (2, 3, 4) se voyant attribuer l'un des éléments de raccordement (11, 12, 13), le circuit de mesure (7) présentant un système de détection de tension (34) destiné à mesurer la tension de mesure appliquée de façon égale à tous les éléments de raccordement (11, 12, 13), ainsi qu'une pluralité de systèmes de détection de courant (23, 24, 25),
dans lequel les systèmes de détection de courant (23, 24, 25) se trouvent à un potentiel de tension de mesure et sont en contact respectivement avec un élément de raccordement (11, 12, 13) pour mesurer simultanément le courant attribuable à chaque objet à mesurer (2, 3, 4),
dans lequel le dispositif présente au moins un câble de liaison (14) long d'au moins 10 mètres, pour relier les objets à mesurer (2, 3, 4) aux éléments de raccordement (11, 12, 13) respectivement attribués à ceux-ci, dans lequel l'au moins un câble de liaison (14) comporte, en plus d'un ou de plusieurs brins (37, 38, 39) attribués aux objets à mesurer respectifs, un autre brin (36) ne servant pas à la mise en contact d'un objet à mesurer (2, 3, 4), auquel est également attribué un élément de raccordement (10) se trouvant à un potentiel de tension de mesure sur le dispositif (1), et avec lequel un courant de fuite apparaissant dans le câble de liaison (14) peut être fourni à une dérivation de courant de fuite (19) du dispositif (1), disposée côté circuit de mesure, lorsque le brin (36) est relié à l'élément de raccordement (10) attribué à celui-ci, et dans lequel tous les brins (36, 37, 38, 39) du câble de liaison (14) sont enrobés dans une couche conductrice ou semiconductrice (40), laquelle est en contact électrique avec le brin (36) du câble de liaison (14) servant à la dérivation du courant de fuite, et laquelle est entourée par une isolation principale (41) du câble de liaison (14).

2. Dispositif selon la revendication 1,
**caractérisé en ce que**
il est prévu un système de détection de courant de fuite dans la dérivation du courant de fuite (19).

3. Dispositif selon la revendication 1 ou 2,
**caractérisé en ce que**
le dispositif (1) présente précisément un câble de liaison (14) à plusieurs brins d'au moins 10 mètres de long, dans lequel un brin (37, 38, 39) du câble de liaison (14) est attribué à chaque objet à mesurer (2, 3, 4), avec lequel l'objet à mesurer (2, 3, 4) respectif est mis en liaison conductrice avec l'élément de raccordement (11, 12, 13) attribué à celui-ci aux fins du diagnostic.

4. Dispositif selon l'une des revendications précédentes,
**caractérisé en ce que**
le dispositif (1) est conçu pour diagnostiquer simultanément trois objets à mesurer (2, 3, 4) au total, et présente à cette fin trois éléments de raccordement (11, 12, 13) se trouvant à un potentiel de tension de mesure, pour le raccordement des brins (36, 37, 38) de l'au moins un câble de liaison (14) attribués aux trois objets à mesurer (2, 3, 4) concernés, et trois systèmes de détection de courant (23, 24, 25) en contact avec les éléments de raccordement (11, 12, 13) respectifs, dans lequel les trois objets à mesurer (2, 3, 4) sont les trois brins d'un câble haute tension triphasé, lesquels sont quant à eux mis en contact avec les brins (37, 38, 39) attribués à ceux-ci de l'au moins un câble de liaison (14) du dispositif (1), aux fins du diagnostic.

5. Dispositif selon l'une des revendications précédentes,
**caractérisé en ce que**
l'au moins un câble de liaison (14) présente une longueur (L) de 20 à 200 mètres, de façon particulièrement préférentielle de 50 à 100 mètres.

6. Dispositif selon l'une des revendications précédentes,
**caractérisé en ce que**
le générateur de haute tension (5) est conçu pour produire une tension alternative servant de tension de mesure, avec une valeur effective supérieure à 1 kV, de préférence supérieure à 20 kV ou mieux, supérieure à 50 kV.

7. Dispositif selon la revendication 3 et la revendication 6,
**caractérisé en ce que**
les brins (37, 38, 39) du câble de liaison (14) attribués aux différents objets à mesurer (2, 3, 4) sont isolés les uns des autres à l'aide d'une isolation conçue pour au moins 100 V.

8. Utilisation d'un dispositif selon l'une des revendications précédentes,
**caractérisée en ce que**
le dispositif (1) est solidement incorporé dans un véhicule de mesure.

9. Procédé pour l'exécution d'un diagnostic simultané d'une pluralité d'objets à mesurer (2, 3, 4) à l'aide d'un dispositif (1) selon l'une des revendications 1 à 7, **caractérisé en ce que** par les étapes suivantes :
A) établissement d'un contact conducteur entre les différents objets à mesurer (2, 3, 4) et les éléments de raccordement (11, 12, 13) du dispositif (1) attribués à ceux-ci, à l'aide de l'au moins un câble de liaison (14) du dispositif (1), et raccordement de l'au moins un brin (36) de l'au moins un câble de liaison (14) servant à la dérivation du courant de fuite à un élément de raccordement (10) du dispositif (1) servant à la dérivation du courant de fuite,
B) production d'une tension de mesure se trouvant dans la plage de haute tension à l'aide du générateur de haute tension (5),
C) mesure simultanée de la tension de mesure à l'aide du système de détection de tension (34) et des courants attribuables aux différents objets à mesurer (2, 3, 4) à l'aide des au moins deux systèmes de détection de courant (23, 24, 25).
